(19) Europäisches Patentamt / European Patent Office / Office européen des brevets

(11) **EP 2 605 409 B1**

(12) **FASCICULE DE BREVET EUROPEEN**

(45) Date de publication et mention
de la délivrance du brevet:
**03.05.2017 Bulletin 2017/18**

(51) Int Cl.:
*H03M 1/48* *(2006.01)*     *G01T 1/17* *(2006.01)*
*H03M 3/02* *(2006.01)*

(21) Numéro de dépôt: **12196856.4**

(22) Date de dépôt: **13.12.2012**

(54) **Numérisation asynchrone de signaux transitoires issus de détecteurs de rayonnement**

Asynchrone Digitalisierung von transienten Signalen aus Strahlungsdetektoren

Asynchronous digitisation of transient signals from radiation detectors

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.12.2011 FR 1161546**

(43) Date de publication de la demande:
**19.06.2013 Bulletin 2013/25**

(73) Titulaire: **Commissariat à l'Énergie Atomique
et aux Énergies Alternatives
75015 Paris (FR)**

(72) Inventeur: **Montemont, Guillaume
38000 Grenoble (FR)**

(74) Mandataire: **Ilgart, Jean-Christophe et al
BREVALEX
95, rue d'Amsterdam
75378 Paris Cedex 8 (FR)**

(56) Documents cités:
WO-A1-97/07591     WO-A1-2011/039819
US-A1- 2011 006 937     US-A1- 2011 210 235

## Description

### DOMAINE TECHNIQUE

La présente invention concerne le domaine de la détection de rayonnement électromagnétique haute fréquence et plus particulièrement celui du traitement de signaux de dispositifs de détection de rayons X ou gamma.

Elle prévoit une méthode améliorée de numérisation d'un signal de détection sous forme d'impulsions issues d'un détecteur de rayonnement électromagnétique ainsi qu'un dispositif de numérisation d'un signal de détection.

L'invention trouve des applications notamment dans le domaine de l'imagerie spectrométrique, en particulier pour la médecine nucléaire, la scintigraphie ou la tomographie photonique.

### ART ANTÉRIEUR

Dans le domaine de la spectrométrie X ou gamma, une chaîne de traitement électronique permet de former un spectre à partir de signaux fournis par un ensemble de détecteurs.

Chaque signal issu d'un détecteur est sous forme d'une impulsion d'une amplitude proportionnelle à l'énergie de photons captés par ce détecteur. Ce signal analogique est amplifié, mis en forme, puis converti en valeur numérique.

Il existe des dispositifs de numérisation dans lesquels on effectue un codage de l'amplitude des impulsions.

Ces dispositifs comprennent au moins un convertisseur analogique numérique CAN lent ayant par exemple un temps de conversion de l'ordre 1 MS/s mais ayant une précision élevée et qui peut être typiquement supérieure à 14 bits.

Des convertisseurs à rampe ou à approximation successives peuvent être utilisés pour effectuer cette numérisation.

Avec une telle méthode de numérisation, on ne dispose que d'une seule information d'amplitude par impulsion ce qui ne permet pas de mettre en oeuvre une analyse fine du signal détecté.

Il existe également des dispositifs de numérisation synchrones dans lesquels on échantillonne directement un signal sous forme d'impulsions à haute fréquence, à la sortie d'un préamplificateur ou après un filtre de conditionnement.

Dans ce type de dispositif, les convertisseurs analogiques numériques utilisés peuvent être plus rapides et moins précis.

Cependant, ce type de dispositif, lorsqu'il est mis en oeuvre pour un nombre de voies de détection important, entraine une consommation élevée.

Des systèmes de conversion analogique-numérique synchrones utilisant par exemple un convertisseur à rampe, ou un convertisseur à approximations successives, et delta-sigma, dans lesquels on compare un signal à coder à un signal estimé, cette comparaison permettant ensuite d'encadrer le signal entre deux enveloppes, sont également connus.

Les signaux issus de détecteurs de rayons X ou gamma étant généralement des signaux transitoires sous forme d'impulsions représentatives d'événements rares et rapides, il peut s'avérer plus efficace pour effectuer une numérisation d'utiliser des convertisseurs analogique-numérique asynchrones.

Le document US 7 466 258 présente un dispositif de numérisation asynchrone semblable à un convertisseur de type flash, et qui est doté de plusieurs comparateurs en parallèle comparant le signal à encoder à un ensemble de valeurs de références et codant le résultat de manière asynchrone.

Un tel dispositif permet une conversion rapide mais nécessite une mise en oeuvre d'un nombre relativement important de comparateurs, ce qui entraine un encombrement et un coût importants.

Le document US 7 218 264 divulgue un dispositif de numérisation asynchrone à plusieurs étages dont le fonctionnement est similaire à un convertisseur de type pipeline. Ce dispositif requiert un comparateur par bit de quantification.

Le document US 4 965 579 présente également un dispositif de numérisation multi-étages asynchrone nécessitant un comparateur par étage et un comparateur par bit de quantification.

Le document US 6 850 180 divulgue un dispositif de numérisation dans lequel un signal d'entrée sous forme d'une impulsion, est encadré à l'aide de deux comparateurs à hystérésis avec un signal issu d'un convertisseur numérique analogique piloté par un circuit logique asynchrone qui augmente ou décroit l'amplitude de ce signal en fonction de la sortie du ou des comparateurs.

Le document US 6 940 444 présente, quant à lui, un système de conversion par approximations successives asynchrone qui a pour inconvénient d'être lent.

Ainsi les systèmes de conversion analogique numérique existants ont l'inconvénient d'être soit lents et imprécis, soit consommateurs en ressources ou en puissance.

Il se pose le problème de trouver un nouveau système de conversion analogique numérique, adapté à la conversion de signaux de détection issus de détecteurs de rayonnement électromagnétique ionisant, tel qu'un rayon X ou un rayon gamma et qui soit amélioré vis-à-vis des inconvénients évoqués ci-dessus.

Le document WO 2011/039819 A1 divulgue un dispositif de numérisation d'un signal de détection issu d'un détecteur de rayonnement électromagnétique conformément au préambule de la revendication 1.

### EXPOSÉ DE L'INVENTION

La présente invention concerne un dispositif de numérisation ou d'échantillonnage d'un signal de détection issu d'un détecteur de rayonnement électromagnétique ionisant, en particulier d'un détecteur de rayons X ou gamma, dont l'énergie est comprise entre quelques eV et quelques MeV, et principalement entre 1 keV et 2 MeV.

Ce dispositif comprend un comparateur agencé de manière à recevoir sur une première de ses entrées, un premier signal dit « signal de détection » sous forme d'au moins une impulsion issue du détecteur, et à délivrer, en fonction d'une comparaison avec un deuxième signal appliqué à une deuxième de ses entrées, un signal de sortie à deux états.

Ce dispositif comprend également des moyens de commande dudit deuxième signal, formant une boucle de rétroaction, le deuxième signal étant délivré à ladite deuxième entrée et dépendant dudit signal de sortie dudit comparateur, de sorte que le sens de variation dudit deuxième signal est fonction de l'état dudit signal de sortie dudit comparateur, les moyens de commande comportant en outre un filtre dit « de lissage ».

Le dispositif de numérisation suivant l'invention comprend en outre : des moyens d'estimation du deuxième signal à l'aide d'instants de basculement dudit signal de sortie du comparateur et des paramètres dudit filtre de lissage.

Parmi les paramètres donnés utilisés pour réaliser cette estimation peut figurer au moins une constante de temps du filtre.

Selon une possibilité de mise en oeuvre, le dispositif de numérisation peut comprendre en outre :

-   des moyens de mémorisation desdits instants de basculement du comparateur,
-   des moyens de mémorisation de valeurs d'un signal produit par lesdits moyens d'estimation, la numérisation étant réalisée en fonction desdites valeurs dudit signal.

Les moyens de commande peuvent comporter des moyens de séquencement, pour autoriser la numérisation dudit premier signal durant une durée donnée $T_{samp}$.

Les moyens de commande peuvent comprendre en outre, entre la sortie du comparateur et ledit filtre de lissage : un bloc numérique ayant une sortie variant entre un état de haute impédance et un état de basse impédance en fonction de l'état desdits moyens de séquencement.

Le bloc numérique peut comprendre :

des moyens commutateurs prévus pour,

-   lorsqu'ils sont activés, modifier la sortie dudit bloc numérique en fonction dudit signal de sortie du comparateur,
-   lorsqu'ils sont désactivés, placer ladite sortie dudit bloc numérique dans un état de haute impédance, les moyens de séquencement étant prévus pour activer lesdits moyens commutateurs pendant ladite durée d'échantillonnage en fonction d'un changement d'état dudit signal de sortie du comparateur.

Les moyens de séquencement peuvent comprendre au moins un multivibrateur monostable ou une machine d'états.

Les moyens d'estimation peuvent être sous forme d'un circuit numérique, FPGA, ou microprocesseur, ou ASIC.

Le filtre de lissage peut être sous forme d'un filtre passe-bas analogique ou numérique.

Les moyens de commande peuvent comprendre un noeud connecté à ladite deuxième entrée, le noeud étant connecté à :

-   des moyens formant au moins une capacité C,
-   des moyens formant une première résistance $R_1$ connectée en sortie dudit bloc numérique,
-   des moyens formant une deuxième résistance $R_2$ connectée à un potentiel fixe $V_E$ et telle que $R_2>R_1$.

Selon une possibilité de mise en oeuvre, les moyens d'estimation peuvent produire un signal discret, le dispositif de numérisation comprenant en outre : des moyens d'interpolation pour réaliser une interpolation dudit signal discret.

La présente invention concerne également un dispositif détecteur de rayonnement électromagnétique ionisant, en particulier de rayonnement X ou gamma, comprenant un dispositif de numérisation tel que défini plus haut.

La présente invention concerne également procédé de numérisation d'un signal de détection issu d'un détecteur de rayonnement électromagnétique ionisant, comportant des étapes consistant à :

-   comparer un premier signal de détection issu dudit détecteur sous forme d'au moins une impulsion et un deuxième signal, et délivrer, en fonction de cette comparaison un signal de sortie à deux états,
-   commander ledit deuxième signal en fonction dudit signal de sortie dudit comparateur, de telle sorte que le sens de variation dudit deuxième signal dépend de l'état dudit signal de sortie dudit comparateur,
-   estimer ledit deuxième signal à l'aide d'instants de basculement dudit signal de sortie du comparateur et de paramètres d'un filtre de lissage,

Le procédé peut comprendre en outre des étapes consistant à :

-   mémoriser des instants de basculement du comparateur,
-   mémoriser une des valeurs d'estimations du deuxième signal.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un exemple de dispositif de conversion analogique numérique suivant l'invention pour la conversion de signaux impulsionnels, en particulier issus de détecteurs de rayonnement gamma ou X ;
- la figure 2 illustre des exemples de signaux mis en oeuvre au sein d'un dispositif de détection de rayonnement électromagnétique haute fréquence comprenant un dispositif d'échantillonnage ou de numérisation mis en oeuvre suivant l'invention ;
- la figure 3 illustre d'autres exemples de signaux mis en oeuvre au sein d'un dispositif de détection de rayonnement électromagnétique ionisant suivant l'invention ;
- les figures 4A et 4B illustrent différents modes de fonctionnement et un dispositif de numérisation selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

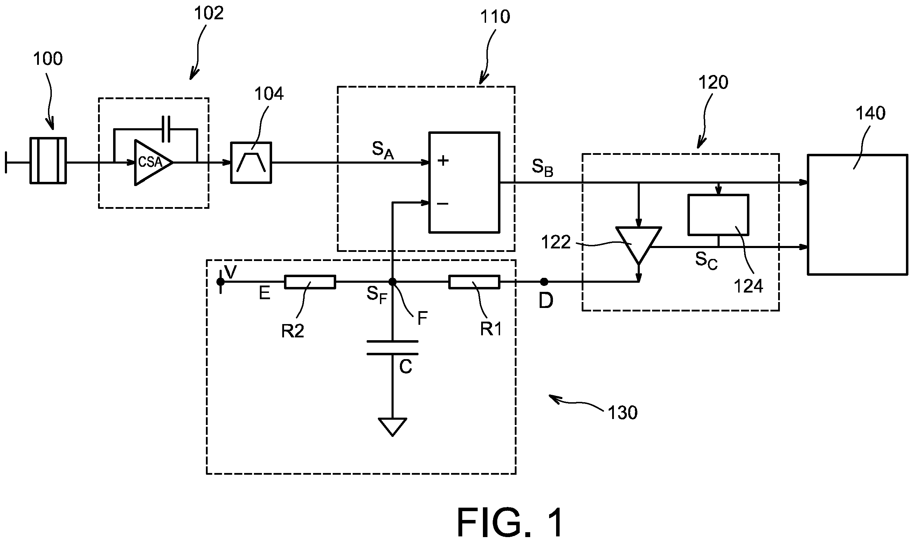

Un exemple de dispositif de numérisation ou d'échantillonnage suivant l'invention, appartenant ou associé à un dispositif microélectronique de détection de rayonnement électromagnétique, et en particulier un dispositif détecteur de rayonnement X ou y, est illustré sur la figure 1.

Le dispositif électronique de détection comprend au moins un détecteur 100 formé d'un matériau dans lequel le rayonnement ionisant interagit, chaque interaction produisant des porteurs de charges, ces derniers étant collectés par des électrodes disposées sur une face dudit matériau détecteur.

En sortie du détecteur, un étage 102 d'amplification comprenant par exemple un amplificateur de charge CSA (CSA pour « Charge Sensitive Amplifier »), et un étage 104 de filtrage comprenant par exemple un filtre passe bande peuvent être prévus, afin, respectivement, d'amplifier le signal détecté et de conserver les fréquences d'intérêt dans lesquelles le rapport signal sur bruit est maximal.

Le dispositif de numérisation comprend tout d'abord des moyens formant un comparateur 110 dont une première entrée, par exemple son entrée non-inverseuse est placée en sortie de l'étage 104 de filtrage.

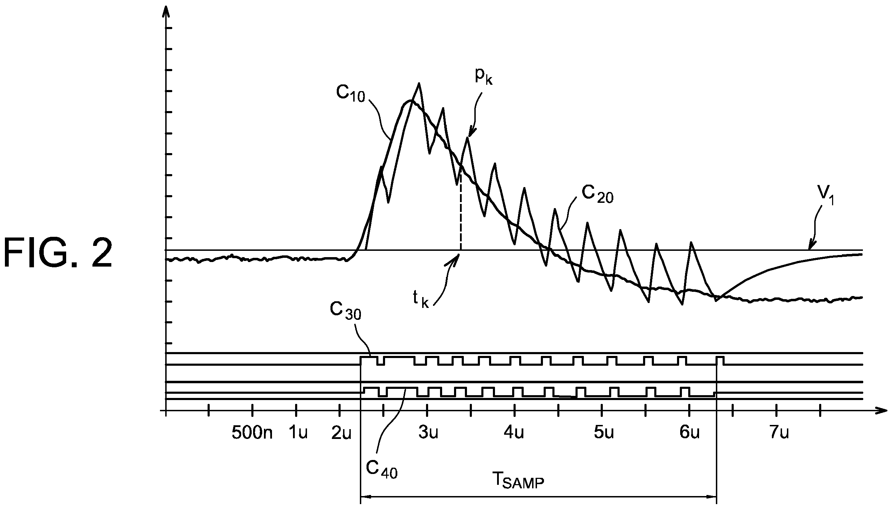

Ainsi, un signal de détection amplifié et filtré SA est injecté en entrée du comparateur 110. Ce signal de détection SA peut être un signal transitoire, sous forme d'une impulsion par exemple du type de celle dont une courbe représentative $C_{10}$ est donnée sur la figure 2.

Sur la deuxième entrée du comparateur 110, par exemple son entrée inverseuse, un signal $S_F$ issu d'un bloc analogique 130 faisant partie d'une boucle de rétroaction connectée à la sortie du comparateur 110 est appliqué.

Un exemple de courbe $C_{20}$ représentative du signal $S_F$ analogique issu dudit bloc analogique 130 est donné sur la figure 2. La courbe représentative du signal $S_F$ a une forme en dents de scie et suit l'évolution du signal SA de détection, tout en oscillant autour de ce dernier.

Ainsi, le signal analogique $S_F$ appliqué en entrée inverseuse du comparateur 110 tient compte de variations passées du signal SA de détection amplifié et filtré.

Suivant, le résultat de la comparaison SA - $S_F$ effectuée par le comparateur 110, le signal $S_B$ délivré en sortie de ce dernier peut adopter un premier état, par exemple un état haut ou un deuxième état, par exemple un état bas.

Un exemple de représentation $C_{30}$ du signal délivré en sortie du comparateur 110 en réponse aux signaux représentés par les courbes $C_{10}$ et $C_{20}$ respectivement en entrée non-inverseuse et en entrée inverseuse, est également donné sur la figure 2.

Le signal $S_B$ numérique de sortie du comparateur 110 sert de signal d'entrée à un bloc numérique 120 appartenant à la boucle de rétroaction entre la sortie et l'entrée inverseuse du comparateur 110.

Ce bloc numérique 120 peut être formé d'une porte logique 122 3 états dont l'entrée peut être connectée à la sortie du comparateur 110 et qui est destinée à être activée ou désactivée en fonction de l'état d'un signal d'activation $S_C$ délivré par un bloc 124 de séquencement, le signal d'activation $S_C$ dépendant lui-même du signal $S_B$ de sortie du comparateur 110.

Selon un exemple, la porte 122 peut être activée lorsque le signal $S_C$ est à un état haut, tandis qu'elle est désactivée lorsque le signal $S_C$ est à un état bas.

Le bloc 124 de séquencement peut être par exemple prévu pour délivrer un signal d'activation de la porte 122 en fonction de changements d'états du signal $S_B$ de sortie du comparateur 110.

Le bloc 124 de séquencement peut être par exemple réalisé à l'aide d'un multivibrateur monostable déclenché par exemple par un front montant de $S_B$ alors que sa sortie $S_C$ est à l'état bas.

Par front montant de $S_B$, on entend un changement d'état, d'un état bas vers un état haut du signal $S_B$ numérique en sortie du comparateur 110. Le bloc 124 de séquencement permet de maintenir, via la sortie $S_C$,

la porte 122 activée durant une durée donnée $T_{samp}$. La durée $T_{samp}$, durant laquelle la porte 122 est activée, est comparable à la durée de l'impulsion que l'on souhaite numériser.

La durée $T_{samp}$ peut être comprise par exemple entre 10 ns et 10 μs selon le détecteur 100 et le filtre 104 utilisés.

Selon une autre possibilité, le bloc 124 de séquencement peut être mis en oeuvre à l'aide d'un circuit logique formant une machine à états permettant d'émettre en sortie un signal d'activation pendant une période donnée $T_{samp}$ ou une durée prédéterminée donnée $T_{samp}$ suite à une détection d'un basculement lorsque l'amplitude du signal SA devient supérieure à celle du signal analogique $S_F$ alors que la sortie de la machine à états est à l'état bas.

Cette période donnée $T_{samp}$ ou durée donnée $T_{samp}$ (indiquée sur la figure 2) correspond à une durée pendant laquelle un échantillonnage est susceptible d'être réalisé.

Le dispositif d'échantillonnage peut être ainsi prévu de sorte qu'en dehors de la période d'échantillonnage $T_{SAMP}$ le bloc numérique 120 est au repos. Si ce bloc est réalisé par exemple en technologie CMOS, sa consommation est alors minimale en dehors de la période d'échantillonnage.

A l'issue de la période donnée $T_{samp}$, la porte 122 est de nouveau désactivée.

Par « désactivée », on entend que quelque soit le signal de sortie $S_B$ du comparateur 110 appliqué en entrée de la porte 122, la sortie D de cette dernière est inchangée et mise par exemple dans un état de haute impédance.

A l'issue d'une période d'échantillonnage, on peut maintenir le bloc numérique au repos durant une période $T_{inhib}$, préalablement déterminée. Cela peut être réalisé en disposant un multivibrateur monostable supplémentaire (non représenté), désactivant le bloc 124 durant une durée $T_{inhib}$, lorsque le signal $S_C$ passe de l'état 1 à l'état 0, et cela indépendamment de $S_B$.

Le passage du signal $S_C$ de l'état 1 à l'état 0 correspond à la désactivation de la porte 122 précédemment évoquée.

Lorsque la porte 122 est « activée » pendant la période donnée $T_{samp}$, l'état de la sortie D de cette dernière dépend de celui du signal de sortie $S_B$ du comparateur 110.

Le fonctionnement de la porte 122 peut être tel que lorsqu'elle est activée, par exemple par un état haut du signal $S_C$ en sortie du bloc 124, sa sortie est mise dans un état « bas » lorsque le signal $S_B$ est à l'état « bas » et sa sortie est mise dans un état « haut » lorsque le signal $S_B$ est à l'état « haut ».

La porte 122 forme ainsi des moyens commutateurs dont l'activation est commandée par le signal d'activation $S_C$ et dont l'état, lorsque ces derniers sont activés, est fonction de celui du signal $S_B$. La porte 122 est par exemple constituée par des portes logiques CMOS.

Dans cet exemple, la sortie D du module numérique 120 constitue une entrée du bloc analogique 130 délivrant le signal en entrée inverseuse du comparateur 130 et complétant la boucle de rétroaction.

Le bloc analogique peut être formé de moyens réalisant un filtre de lissage du signal délivré à la sortie D du module numérique, par exemple un filtrage passe bas. Le signal délivré à la sortie D du module numérique correspond à la sortie de la porte 122, cette dernière dépendant de la sortie $S_B$ du comparateur 110. Ainsi, de façon générale, le bloc analogique 130 permet d'effectuer un lissage du signal de sortie du comparateur $S_B$. Un tel lissage peut être obtenu à l'aide d'un filtre RC.

Le bloc analogique 130 peut comprendre un noeud F relié à l'entrée inverseuse du comparateur 110 et auquel des moyens formant un condensateur C également relié à un potentiel de masse GND ou Vss peuvent être connectés.

Des moyens réalisant une première résistance $R_1$ sont formés entre la sortie D du module numérique 120 et le noeud F, tandis que des moyens formant une deuxième résistance $R_2$ sont prévus entre un noeud E mis à un potentiel $V_E$ et le noeud F. Lorsque la sortie D est placée en mode haute impédance, le signal Sc étant à 0 ou à un état bas, la constante de temps du filtre de lissage est : $R_2C$. Lorsque la sortie D est placée en mode passant, le signal Sc est à 1 ou à un état haut, la constante de temps du filtre de lissage est : $R_1C$.

Les valeurs de la première résistance $R_1$, de la deuxième résistance $R_2$, et de la capacité C, peuvent être prévues en fonction d'une prédiction ou d'une estimation du signal SA délivré en entrée non-inverseuse du comparateur 110, et en particulier d'une estimation de sa pente.

Plus précisément, le lissage est effectué de tel sorte que la pente du signal de rétroaction, après lissage, est supérieure à la pente maximale de l'impulsion reçue en entrée du dispositif et que l'on souhaite numériser. Sa pente doit être par exemple être comprise entre $1+\varepsilon$ avec $\varepsilon$ par exemple appartenant

à $]0;1[$ et 2 fois la pente maximale de l'impulsion à numériser.

Par signal de rétroaction, on entend le signal $S_F$ appliqué à l'entrée inverseuse du comparateur 110 lors de l'échantillonnage lorsque le signal Sc = 1 ou est à l'état haut. Il s'agit du signal que l'on applique à l'entrée inverseuse du comparateur 110 sous l'effet du basculement de ce dernier. Dans cet exemple, ce signal est commandé par la porte 122.

Le potentiel $V_E$ est un potentiel fixe, permettant d'établir une valeur $V_1$ de départ du signal $V_F$ en entrée inverseuse du comparateur 110, lorsque la sortie D du module numérique est en haute impédance avant que ne débute l'impulsion. Cette valeur $V_1$ est prévue de sorte à empêcher un basculement intempestif de la sortie du comparateur avant le début de l'échantillonnage de l'impulsion.

Ainsi, on peut prévoir des valeurs pour $R_1$, $R_2$, et C, à partir d'une estimation préalable de la rampe ou pente d'un signal destiné à être détecté. Par exemple, pour un signal tel que celui illustré par la courbe $C_{10}$ sur la figure 2, une estimation d'une portion comprise entre 2.2 $\mu$s et 2.7 $\mu$s, c'est à dire la portion la plus pentue de la courbe $C_{10}$ peut permettre de déterminer des valeurs pour $R_1$, $R_2$, et C.

La première résistance $R_1$ peut être prévue supérieure à la deuxième résistance $R_2$. La première résistance $R_1$ peut être prévue par exemple de l'ordre de 100 k$\underline{\Omega}$ tandis que la deuxième résistance $R_2$ peut être prévue par exemple de l'ordre de 20 K$\underline{\Omega}$, la capacité C étant par exemple de l'ordre de 10 pF.

Le filtre passe bas peut avoir une première constante de temps $\tau_1$ dite « lente » et de l'ordre de $R_1$*C lorsque la sortie D du module numérique 120 est en basse impédance du fait par exemple d'un état haut du signal $S_C$ d'activation lorsque la porte 122 3 états est active.

Le filtre passe bas peut également avoir une deuxième constante de temps $\tau_2$ dite « rapide » et de l'ordre de $R_2$*C lorsque la sortie D du module numérique 120 est en haute impédance du fait d'un état bas du signal $S_C$ lorsque la porte 122 3 états est inactive. Le fait d'avoir une constante de temps $\tau_2$ rapide permet à l'entrée inverseuse de retrouver l'état de repos V = $V_E$ rapidement après la fin de la période d'échantillonnage. La période d'inhibition $T_{inhib}$ préalablement décrite peut être définie en fonction de cette constante de temps $\tau_2$ rapide.

Selon une variante, les constantes de temps $\tau_1$ et $\tau_2$ peuvent être du même ordre de grandeur.

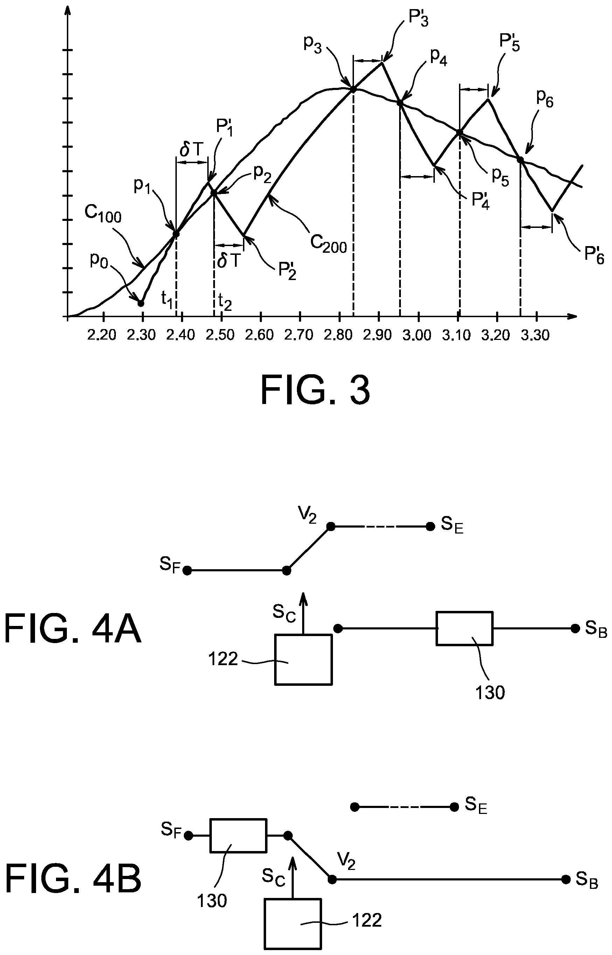

Ainsi, d'une façon générale, le dispositif de numérisation peut commuter d'un mode « inactif », ou « inhibé », à un mode « actif », ou de « numérisation », sous l'effet du commutateur 122, comme cela est illustré sur les figures 4A et 4B.

Lorsque le dispositif est inhibé, l'entrée non inverseuse du comparateur 110 est connectée à un potentiel fixe $V_E$ tandis qu'en mode numérisation, l'entrée non inverseuse est reliée à la sortie du comparateur 110, par l'intermédiaire du filtre de lissage.

Ce filtre de lissage peut être analogique, comme dans l'exemple donné précédemment, ou, selon d'autres possibilités, être numérique ou comprendre une partie numérique et une partie analogique.

L'échantillonnage du signal $S_A$ peut être tel que les valeurs de ce dernier qui sont capturées le sont de manière irrégulière et correspondent à des instants du signal $S_A$ où ce dernier est égal au signal analogique $S_F$.

Sur la figure 2, des points de croisement $p_k$ avec k $\in$ [1;n] (avec n entier) entre la courbe $C_{10}$ du signal de détection en entrée non inverseuse du comparateur 110 et celle $C_{20}$ du signal analogique $S_F$ de rétroaction en entrée inverseuse du comparateur 110 sont illustrés.

Ces points de croisement sont les points d'échantillonnage du signal de détection SA que le dispositif suivant l'invention permet de déterminer ou d'évaluer.

Ces points d'échantillonnage $p_k$ correspondent à au moins un temps de propagation près aux instants de basculement $t_k$ du signal $S_B$ en sortie comparateur. Ce temps de propagation peut être par exemple de 10 ns.

Ainsi, les instants de basculement du comparateur 110, déterminés par les variations du signal $S_B$ en sortie comparateur, peuvent être exploités pour déterminer les instants $t_k$ où l'amplitude du signal de détection $S_A$ est égale à celle du signal $S_F$ (la courbe du signal de détection $S_A$ et la courbe du signal analogique $S_F$ de rétroaction se croisant aux instants $t_k$ indiqués sur la figure 2).

Un registre à décalage ou un compteur peut être éventuellement utilisé pour permettre de stocker éventuellement un historique des instants de basculement du comparateur 110.

Autrement dit, d'une façon générale, au cours de l'échantillonnage du signal SA délivré par le détecteur, on enregistre les instants de basculement du comparateur 110, ces derniers correspondant aux instants auxquels la valeur de l'impulsion SA est égale au signal de rétroaction $S_F$ appliqué au comparateur, ce dernier étant généré à chaque basculement du comparateur.

Comme cela est illustré sur la figure 3 par les courbes $C_{100}$ et $C_{200}$ représentatives respectivement d'un signal de détection $S_A$ et d'un signal $S_F$ de rétroaction en entrée inverseuse du comparateur 110, les instants auxquels le signal $S_F$ de rétroaction atteint des pics $P'_k$ k $\in$ [1;n] (avec n un entier) correspondent également aux instants $t_k$ d'échantillonnage, au délai de propagation $\delta T$ près dans la boucle de rétroaction.

A un point $p_0$, la valeur du signal $S_A$ dépasse un seuil $V_1$, ce qui active la numérisation. La boucle de rétroaction fait croître le signal $S_F$ de rétroaction appliqué à l'entrée non inverseuse du comparateur 110 sous l'effet d'un état haut en sortie du comparateur $S_B$.

A un instant $t_1$ (point $p_1$), l'amplitude du signal de rétroaction devient égale à celle du signal de détection $S_A$. Un basculement du comparateur 110 est alors déclenché et le signal de sortie $S_B$ du comparateur 110 passe à l'état bas. Après cet instant $t_1$, l'amplitude du signal $S_A$ est inférieure à celle du signal $S_F$. La pente du signal $S_F$ de rétroaction atteint ensuite un maximum local (point $P'_1$), puis décroit. Le décalage temporel entre l'instant $t_1$ et le maximum local du signal de rétroaction lui succédant correspond au délai $\delta T$ de la boucle de rétroaction.

A un instant $t_2$ (point $p_2$ de croisement entre $C_{100}$ et $C_{200}$), le signal $S_F$ de rétroaction et le signal de détection $S_A$ ont des amplitudes égales, le signal de sortie $S_B$ du comparateur 110 passant à l'état haut. Après cet instant $t_2$, l'amplitude du signal $S_F$ est inférieure à celle du signal de détection $S_A$, le signal $S_F$ atteignant tout d'abord un minimum local (point $P'_2$), puis augmentant. Le décalage temporel entre l'instant $t_2$ et le minimum local du signal de rétroaction correspond au délai $\delta T$ de

la boucle de rétroaction.

A un instant $t_3$ (point $p_3$ de croisement entre $C_{100}$ et $C_{200}$) le comparateur 110 bascule et son signal de sortie $S_B$ passe à l'état bas. De ce fait, la pente du signal de rétroaction $S_F$ diminue, ce signal atteignant un maximum local (point P'$_3$), puis diminue.

Le décalage temporel entre l'instant $t_3$ et le maximum local point P'$_3$ du signal de rétroaction lui succédant correspond au délai $\delta T$ de la boucle de rétroaction.

D'une façon générale, le signal de rétroaction $S_F$ commandé par le basculement du comparateur 110, encadre le signal de détection $S_A$, à numériser en étant commandé par la sortie du comparateur, la pente, ou sens de variation, du signal de rétroaction augmentant lorsque $S_F < S_A$ et diminuant lorsque $S_F > S_A$.

Les valeurs d'amplitude du signal de détection $S_A$ correspondant aux instants de croisement entre $S_A$ et le signal $S_F$ peuvent être déterminés à l'aide de moyens d'estimation 140 sous forme d'un module numérique 140. Ces moyens d'estimation 140 comprennent des moyens de calcul utilisant une estimation de ces instants de croisement et permettant d'effectuer un calcul de l'équation différentielle du premier ordre suivante :

$$dS_F/dt = (S_D - S_F)/(R_1*C) + (S_E - S_F)/(R_2*C).$$

On va à présent décrire des étapes du procédé d'échantillonnage ou de numérisation mis en oeuvre suivant l'invention :

On extrait des temps ou instants de basculement $t_k$ du comparateur, par exemple sous la forme d'un signal $S_G$.

On effectue ensuite une reconstruction numérique du signal $S_F$. Pour cela, on effectue une estimation du signal $S_F$ à l'aide du signal $S_B$, des temps de propagation des différents composants de la boucle de rétroaction et de la connaissance des paramètres du filtre de lissage et en particulier de sa constante de temps.

Le délai entre un instant où les signaux $S_F$ et $S_A$ sont égaux déclenchant le basculement du comparateur et une inflexion du signal $S_F$ suivant cet instant correspond à un temps de propagation $\delta T$ ou temps de réponse de la boucle de rétroaction.

Cette reconstruction numérique permet de produire un signal numérique discret $S_F$'. La reconstruction numérique peut être effectuée à l'aide d'un circuit numérique de calcul, comprenant par exemple un microprocesseur, ou un FPGA (FPGA pour « field programmable gate array » ou réseau de portes programmables in situ) ou un ASIC (pour « Application-Specific Integrated Circuit, ou « circuit intégré propre à une application »). Ainsi, la reconstruction du signal $S_F$ est obtenue en connaissant la réponse de la boucle de rétroaction à chaque déclenchement du comparateur 110.

Ensuite, on peut réaliser une mémorisation du signal numérique $S_F$' aux instants de basculement $t_k$ constituant le signal $S_G$, ces derniers pouvant être corrigés en fonction du temps de basculement du comparateur.

On peut ensuite effectuer une interpolation entre les différents signaux mémorisés lors de l'étape précédente.

## Revendications

1. Dispositif de numérisation d'un signal de détection issu d'un détecteur de rayonnement électromagnétique ionisant comprenant :

   - un comparateur (110) destiné à recevoir sur une première de ses entrées un premier signal de détection ($S_A$) issu dudit détecteur sous forme d'au moins une impulsion, et à délivrer, en fonction d'une comparaison avec un deuxième signal ($S_F$) appliqué à une deuxième de ses entrées, un signal de sortie ($S_B$) à deux états,
   - des moyens de commande (120, 130) formant une boucle de rétroaction pilotant ledit deuxième signal ($S_F$) en fonction dudit signal de sortie ($S_B$) dudit comparateur, de telle sorte que le sens de variation dudit deuxième signal ($S_F$) dépend de l'état dudit signal de sortie ($S_B$) dudit comparateur (110), les moyens de commande comportant un filtre de lissage ayant des paramètres (Ri, $R_2$, C) donnés,

   **caractérisé en ce que** le dispositif de numérisation comporte en outre :

   - des moyens d'estimation (140) du deuxième signal ($S_F$) produisant une estimation du deuxième signal sous forme d'un signal discret ($S'_F$) à l'aide d'instants de basculement dudit signal de sortie ($S_B$) du comparateur (110), des temps de propagation des différents composants de la boucle de rétroaction, et desdits paramètres donnés ($R_1$, $R_2$, C) dudit filtre de lissage,
   - des moyens de mémorisation desdits instants de basculement du comparateur (110),
   - des moyens de mémorisation de valeurs du signal discret ($S_{F'}$) aux instants de basculement du comparateur (110), le signal discret ($S_{F'}$) mémorisé aux instants de basculement du comparateur (110) constituant un signal numérique ($S_G$).

2. Dispositif selon la revendication 1, les moyens de commande (120) comportant des moyens (124) de séquencement, pour autoriser la numérisation dudit premier signal ($S_A$) durant une durée donnée

($T_{samp}$).

**3.** Dispositif selon la revendication 2, les moyens de commande (120, 130) comprenant en outre, entre la sortie du comparateur (110) et ledit filtre de lissage (130) : un bloc numérique (120) ayant une sortie (D) variant entre un état de haute impédance et un état de basse impédance en fonction de l'état desdits moyens (124) de séquencement.

**4.** Dispositif selon la revendication 3, le bloc numérique (120) comprenant :

- des moyens commutateurs (122) prévus pour :
- lorsqu'ils sont activés, modifier la sortie (D) dudit bloc numérique (120) en fonction dudit signal de sortie du comparateur,
- lorsqu'ils sont désactivés, placer ladite sortie dudit bloc numérique (120) dans un état de haute impédance,

les moyens (124) de séquencement étant prévus pour activer lesdits moyens commutateurs (122) pendant ladite durée d'échantillonnage en fonction d'un changement d'état dudit signal de sortie ($S_B$) du comparateur (110).

**5.** Dispositif selon la revendication 4, les moyens (124) de séquencement comprenant au moins un multivibrateur monostable ou une machine d'états.

**6.** Dispositif selon l'une des revendications 1 à 5, les moyens d'estimation (140) étant sous forme d'un circuit numérique, FPGA, ou microprocesseur, ou ASIC.

**7.** Dispositif selon l'une des revendications 1 à 6, le filtre de lissage étant sous forme d'un filtre passe-bas.

**8.** Dispositif selon l'une des revendications 1 à 7, les moyens de commande comprenant un noeud (F) connecté à ladite deuxième entrée, le noeud étant connecté à un filtre de lissage doté :

- de moyens formant au moins une capacité C,
- de moyens formant une première résistance $R_1$ connectée en sortie dudit bloc numérique (120),
- de moyens formant une deuxième résistance $R_2$ connectée à un potentiel fixe $V_E$.

**9.** Dispositif selon l'une des revendications précédentes, dans lequel les moyens d'estimation (140) produisent un signal discret ($S_{F'}$) le dispositif comprenant en outre : des moyens d'interpolation pour réaliser une interpolation dudit signal ($S_F$') discret ou dudit signal numérique ($S_G$).

**10.** Dispositif détecteur de rayonnement électromagnétique ionisant, en particulier de rayonnement X ou gamma, comprenant un dispositif de numérisation selon l'une des revendications 1 à 10.

**11.** Procédé de numérisation d'un signal de détection issu d'un détecteur de rayonnement électromagnétique ionisant, comportant les étapes consistant à :

- comparer un premier signal de détection ($S_A$) issu dudit détecteur sous forme d'au moins une impulsion et un deuxième signal ($S_F$), et délivrer, en fonction de cette comparaison un signal de sortie ($S_B$) à deux états,
- commander (120, 130), ledit deuxième signal ($S_F$) en fonction dudit signal de sortie ($S_B$) dudit comparateur, de telle sorte que le sens de variation dudit deuxième signal ($S_F$) dépend de l'état dudit signal de sortie ($S_B$) dudit comparateur (110),

**caractérisé en ce que** le procédé de numérisation comporte en outre les étapes suivantes:

- estimer (140) ledit deuxième signal ($S_F$) à l'aide d'instants de basculement dudit signal de sortie ($S_B$) du comparateur (110), des temps de propagation des différents composants de la boucle de rétroaction, et de paramètres ($R_1$, $R_2$, C) d'un filtre de lissage, et produire un signal discret ($S'_F$) estimé,
- mémoriser des instants de basculement du comparateur (110),
- mémoriser les valeurs du signal discret ($S_{F'}$) mémorisé aux instants de basculement du comparateur (110), le signal discret ($S_{F'}$) mémorisé aux instants de basculement du comparateur (110) constituant un signal numérique ($S_G$).

**Patentansprüche**

**1.** Vorrichtung zur Digitalisierung eines Erfassungssignals, das von einem Detektor für ionisierende elektromagnetische Strahlung stammt, umfassend:

- einen Komparator (110), der dazu ausgelegt ist, an einem ersten seiner Eingänge ein erstes Erfassungssignal ($S_A$) zu empfangen, das in Form wenigstens eines Pulses von dem Detektor stammt, und als Funktion eines Vergleichs mit einem zweiten Signal ($S_F$), das an einen zweiten seiner Eingänge angelegt ist, ein Ausgangssignal ($S_B$) mit zwei Zuständen zu liefern,
- Steuermittel (120, 130), die eine Rückkopplungsschleife zur Steuerung des zweiten Signals ($S_F$) als Funktion des Ausgangssignals ($S_B$) des Komparators derart bilden, dass die Richtung der Variation des zweiten Signals ($S_F$) vom Zustand des Ausgangssignals ($S_B$) des Komparators (110) abhängt, wobei die Steuermittel ein Glättungsfilter mit gegebenen Parametern ($R_1$, $R_2$, C) umfassen, **dadurch gekennzeichnet, dass** die Digitalisierungsvorrichtung ferner umfasst:

- Mittel (140) zur Abschätzung des zweiten Signals ($S_F$), die eine Abschätzung des zweiten Signals in Form eines diskreten Signals ($S'_F$) mithilfe von Umschaltzeitpunkten des Ausgangssignals ($S_B$) des Komparators (110), der Ausbreitungszeiten der verschiedenen Komponenten der Rückkopplungsschleife und der gegebenen Parameter ($R_1$, $R_2$, C) des Glättungsfilters erzeugen,
- Mittel zur Speicherung der Umschaltzeitpunkte des Komparators (110),
- Mittel zur Speicherung von Werten des diskreten Signals ($S_{F'}$) an den Umschaltzeitpunkten des Komparators (110), wobei das an den Umschaltzeitpunkten des Komparators (110) gespeicherte diskrete Signal ($S_{F'}$) ein digitales Signal ($S_G$) bildet.

2. Vorrichtung nach Anspruch 1, wobei die Steuermittel (120) Sequenzierungsmittel (124) umfassen, um die Digitalisierung des ersten Signals ($S_A$) während einer gegebenen Zeitdauer ($T_{samp}$) zu erlauben.

3. Vorrichtung nach Anspruch 2, wobei die Steuermittel (120, 130) ferner zwischen dem Ausgang des Komparators (110) und dem Glättungsfilter (130) einen digitalen Block (120) umfassen, der einen Ausgang (D) aufweist, der als Funktion des Zustands der Sequenzierungsmittel (124) zwischen einem Hochimpedanz-Zustand und einem Tiefimpedanz-Zustand variiert.

4. Vorrichtung nach Anspruch 3, wobei der digitale Block (120) umfasst:

   - Schaltmittel (122), die für folgendes vorgesehen sind:
   - wenn sie aktiviert sind, Modifizieren des Ausgangs (D) des digitalen Blocks (120) als Funktion des Ausgangssignals des Komparators,
   - wenn sie deaktiviert sind, Setzen des Ausgangs des digitalen Blocks (120) in einen Hochimpedanz-Zustand,

   wobei die Sequenzierungsmittel (124) dazu vorgesehen sind, die Schaltmittel (122) während der Abtastzeitdauer als Funktion einer Zustandsänderung des Ausgangssignals ($S_B$) des Komparators (110) zu aktivierten.

5. Vorrichtung nach Anspruch 4, wobei die Sequenzierungsmittel (124) wenigstens einen monostabilen Multivibrator oder eine Zustandsmaschine umfassen.

6. Vorrichtung nach einem der Ansprüche 1 bis 5, wobei die Abschätzmittel (140) die Form einer digitalen Schaltung, FPGA, oder Mikroprozessors, oder ASIC, aufweisen.

7. Vorrichtung nach einem der Ansprüche 1 bis 6, wobei das Glättungsfilter die Form eines Tiefpassfilters aufweist.

8. Vorrichtung nach einem der Ansprüche 1 bis 7, wobei die Steuermittel einen mit dem zweiten Eingang verbunden Knoten (F) umfassen, wobei der Knoten mit einem Glättungsfilter verbunden ist, das ausgestattet ist mit:

   - Mitteln, die wenigstens eine Kapazität C bilden,
   - Mitteln, die einen ersten Widerstand $R_1$ bilden, der am Ausgang des digitalen Blocks (120) angeschlossen ist,
   - Mitteln, die einen zweiten Widerstand $R_2$ bilden, der an ein festes Potenzial $V_E$ angeschlossen ist.

9. Vorrichtung nach einem der vorhergehenden Ansprüche, wobei die Abschätzmittel (140) ein diskretes Signal ($S_{F'}$) erzeugen, wobei die Vorrichtung ferner Interpolationsmittel umfasst, um eine Interpolation des diskreten Signals ($S_{F'}$) oder des digitalen Signals ($S_G$) zu realisieren.

10. Detektorvorrichtung für ionisierende elektromagnetische Strahlung, insbesondere Röntgen- oder Gammastrahlung, umfassend eine Digitalisierungsvorrichtung nach einem der Ansprüche 1 bis 10.

11. Verfahren zur Digitalisierung eines Erfassungssignals, das von einem Detektor für ionisierende elektromagnetische Strahlung stammt, umfassend die folgenden Schritte:

   - Vergleichen eines ersten Erfassungssignals ($S_A$), das in Form wenigstens eines Pulses von dem Detektor stammt, und eines zweiten Signals ($S_F$), und Liefern, als Funktion dieses Vergleichs, eines Ausgangssignals ($S_B$) mit zwei Zuständen,
   - Steuern (120, 130) des zweiten Signals ($S_F$) als Funktion des Ausgangssignals ($S_B$) des Komparators, derart dass die Richtung der Variation des zweiten Signals ($S_F$) vom Zustand des Ausgangssignals ($S_B$) des Komparators (110) abhängt, **dadurch gekennzeichnet, dass** das Digitalisierungsverfahren ferner die folgenden Schritte umfasst:

- Abschätzen (140) des zweiten Signals ($S_F$) mit Hilfe von Umschaltzeitpunkten des Ausgangssignals ($S_B$) des Komparators (110), der Ausbreitungszeiten der verschiedenen Komponenten der Rückkopplungsschleife, und von Parametern ($R_1$, $R_2$, C) eines Glättungsfilters, und Erzeugen eines geschätzten diskreten Signals ($S'_F$),
- Speichern der Umschaltzeitpunkte des Komparators (110),
- Speichern der Werte des an den Umschaltzeitpunkten des Komparators (110) gespeicherten diskreten Signals ($S_{F'}$), wobei das an den Umschaltzeitpunkten des Komparators (110) gespeicherte diskrete Signal ($S_{F'}$) ein digitales Signal ($S_G$) bildet.

**Claims**

1. Device for digitising a detection signal from an ionising electromagnetic radiation detector comprising:

   - a comparator (110) for receiving, on a first of the inputs thereof, a first detection signal ($S_A$) from said detector in the form of at least one pulse, and for delivering, based on a comparison with a second signal ($S_F$) applied to a second of the inputs thereof, a two-state output signal ($S_B$),
   - control means (120, 130) forming a feedback loop controlling said second signal ($S_F$) based on the output signal ($S_B$) of said comparator, such that the direction of variation of said second signal ($S_F$) is dependent on the state of said output signal ($S_B$) of said comparator (110), the control means comprising a smoothing filter having given parameters ($R_1$, $R_2$, C),

   **characterised in that** said device for digitising further comprises :

   - estimation means (140) for estimating the second signal ($S_F$), producing an estimate of the second signal as a discrete digital signal ($S_F'$), using switching times of said output signal ($S_B$) of the comparator (110), of the propagation times of the various components of the feedback loop and of said given parameters ($R_1$, $R_2$, C) of said smoothing filter,
   - means for storing said comparator (110) switching times,
   - means for storing values of the discrete signal ($S_F'$), at the comparator (110) switching times, the discrete signal ($S_F'$), stored at the comparator (110) switching times forming a digital signal ($S_G$).

2. Device according to claim 1, the control means (120, 130) comprising means (124) for sequencing, to authorise the digitisation of said first signal ($S_A$) during a given time ($T_{samp}$).

3. Device according to claim 2, the control means (120, 130) further comprising, between the comparator (110) output and said smoothing filter (130): a digital block (120) having an output (D) varying between a high-impedance state and a low-impedance state based on the state of said means (124) for sequencing.

4. Device according to claim 3, the digital block (120) comprising:

   - switching means (122) envisaged for:
   - when activated, modifying the output (D) of said digital block (120) based on said comparator output signal,
   - when deactivated, setting said output of said digital block (120) to a high-impedance state,

   the means (124) for sequencing being adapted to activate said switching means (122) during said sampling time based on a change of state of said comparator (110) output signal ($S_B$).

5. Device according to claim 4, the means (124) for sequencing comprising at least one monostable multivibrator or a state machine.

6. Device according to any of claims 1 to 5, the estimation means (120) being in the form of a digital, FPGA, or microprocessor, or ASIC circuit.

7. Device according to any of claims 1 to 6, the smoothing filter being in the form of a low-pass filter.

8. A Device according to any of claims 1 to 7, wherein the control means comprise a node (F) connected to said second input, the node being connected to a smoothing filter comprising:

   - means forming at least one capacitance C,
   - means forming a first resistor $R_1$ connected at the output of said digital block (120),
   - means forming a second resistor $R_2$ connected to a fixed potential $V_E$.

9. Device according to any of the above claims, wherein the estimation means (140) generate a discrete signal ($S_F$), the device further comprising: interpolation means for interpolating said discrete signal ($S_F'$) or said digital signal ($S_G$).

10. Device for detecting ionising electromagnetic radiation, particularly X- or gamma-rays, comprising a device for digitising according to any of claims 1 to 9.

**11.** A Method for digitising a detection signal from an ionising electromagnetic radiation detector, comprising steps consisting of:

- comparing a first detection signal ($S_A$) from said detector in the form of at least one pulse and a second signal ($S_F$), and delivering, based on this comparison, a two-state output signal ($S_B$),
- controlling (120, 130) said second signal ($S_F$) based on said output signal ($S_B$) of said comparator, such that the direction of variation of said second signal ($S_F$) is dependent on the state of said output signal ($S_B$) of said comparator (110),

**characterised in that** the method for digitising further comprises the following steps:

- estimating (140) said second signal ($S_F$) using switching times of said comparator (110) output signal ($S_B$), of propagation times of the various components of the feedback loop, and of parameters ($R_1$, $R_2$, $C$) of a smoothing filter, and producing an estimate of a discrete digital signal ($S_F'$),
- storing comparator (110) switching times in memory,
- storing the values of the discrete signal ($S_F'$) in memory, at the comparator (110) switching times, the discrete signal ($S_F'$), stored at the comparator (110) switching times forming a digital signal ($S_G$).

**FIG. 1**

EP 2 605 409 B1

FIG. 2

FIG. 3

FIG. 4A

FIG. 4B

**EP 2 605 409 B1**

## RÉFÉRENCES CITÉES DANS LA DESCRIPTION

**Documents brevets cités dans la description**

- US 7466258 B
- US 7218264 B
- US 4965579 A

- US 6850180 B
- US 6940444 B
- WO 2011039819 A1